# EUROPEAN PATENT APPLICATION

(11) **EP 3 993 078 A1**
(43) Date of publication of application: **04.05.2022**
(21) Application number: 20833090.2
(22) Date of filing: 18.06.2020
(51) Int. Cl.: H01L 51/52, H01L 51/50, H01L 51/00

(54) **ORGANIC ELECTROLUMINESCENT DEVICE**

(30) Priority: 27.06.2019 KR 20190076871
(71) Applicant: Solus Advanced Materials Co., Ltd., Iksan-si, Jeollabuk-do 54584 (KR)
(72) Inventor: HAN, Songie, Yongin-si, Gyeonggi-do 16858 (KR); PARK, Hocheol, Yongin-si, Gyeonggi-do 16858 (KR); KIM, Youngmo, Yongin-si, Gyeonggi-do 16858 (KR); SONG, Hyobum, Yongin-si, Gyeonggi-do 16858 (KR); JUNG, Seungeun, Yongin-si, Gyeonggi-do 16858 (KR); KIM, Geunhyeong, Yongin-si, Gyeonggi-do 16858 (KR); KIM, Taehyung, Yongin-si, Gyeonggi-do 16858 (KR)
(74) Representative: Office Freylinger
(86) International application number: PCT/KR2020/007905
(87) International publication number: WO 2020/262885

(57) **Abstract**

The present invention may provide an organic electroluminescent device comprising an organic functional layer which is provided between a light emitting layer and an electron transport region, and has a refractive index equal to or greater than the refractive index of the corresponding light emitting layer, whereby the organic electroluminescent device simultaneously exhibits high luminous efficiency, low driving voltage, long service life, and the like.

## Description

### Technical Field

The present invention relates to an organic electroluminescent device including an organic functional layer which is provided between an emissive layer and an electron transport region and has a refractive index equal to or greater than that of the corresponding emissive layer, whereby the organic electroluminescent device exhibits improved properties including low driving voltages, high luminous efficiency, and long lifespan.

### Background Art

The study on organic electroluminescent devices (hereinafter abbreviated to "EL devices") led to blue electroluminescence using anthracene monocrystals in 1965, and Tang suggested in 1987 an organic EL device in a bilayer stack structure which is composed of a hole layer (NPB) and an emissive layer (Alq3). Since then, organic EL devices have been developed into multilayer stack structures having organic layers introduced thereinto, each being assigned a distinctive and segmented function, such as an organic layer responsible for hole injection and transport, an organic layer responsible for electron injection and transport, an organic layer responsible for electroluminescent emission by recombination of holes and electrons, etc., so as to achieve high efficiency and long lifespan characteristics necessary for commercialization. The introduction of the multilayer stack structure improved the performance of the organic EL devices up to the level of commercialization, and such a multilayer stack structure has been expanding its application range from portable radio display products in 1997 to portable information display devices and TV display devices.

The demand for larger displays and higher resolutions has led to challenges, for example, high efficiency and long lifespan, for the organic EL devices. Particularly, the high resolution that is realized by forming more pixels in the same area incurs a decrease in a light emitting area of an organic EL pixel, with the consequent outcome of reducing the lifespan, which has thus become one of the most important technical problems to be overcome for the organic EL device.

In the organic EL device, application of a current or voltage to two electrodes injects holes into an organic layer from the anode, and electrons into the organic layer from the cathode. When the injected holes and electrons recombine, an exciton is produced and then returns to the ground state, emitting light. Such organic EL devices may be classified, according to an electron spin type of the formed excitons, into fluorescent EL devices in which singlet excitons contribute to light emission and phosphorescent EL devices in which triplet excitons contribute to light emission.

According to the electron spin statistics, the excitons are produced at an amount ratio of 25% singlet: 75% triplet by recombination of electrons and holes. In the fluorescent EL devices which emit light by singlet excitons, the internal quantum efficiency may not theoretically exceed 25% depending on the production ratio, and the external quantum efficiency is regarded to have a limit of 5%. The phosphorescent EL devices which emit light by triplet excitons may improve luminous efficiency by up to four times compared to fluorescence, when metal complex compounds containing transition metal heavy atoms such as Ir and Pt are used as phosphorescent dopants.

Although the phosphorescent EL devices exhibit higher efficiency than fluorescence in terms of luminous efficiency based on the theoretical fact as described in the foregoing, blue phosphorescent devices, except green and red phosphorescent devices, have not been commercialized yet, but blue fluorescent devices have been used in products because the development level for phosphorescent dopants having deep blue color purity and high efficiency and hosts having a broad energy gap to satisfy such phosphorescent dopants is insufficient.

In order to improve such characteristics of the organic EL device, research results to increase the stability of the organic EL device by preventing diffusion of holes into an electron transport layer have been reported, but no satisfactory outcomes have been obtained to date.

### Disclosure of Invention

### Technical Problem

The present invention is directed to providing an organic EL device including at a site adjacent to the emissive layer an organic functional layer as same as or higher than an emissive layer (e.g., light emitting layer) material in terms of refractive index, thereby achieving high efficiency and low voltage, and long life characteristics.

### Solution to Problem

The present invention is directed to providing an organic EL device having a structure in which an anode; a hole transport area; an emissive layer; an electron transport area; and a cathode are sequentially stacked, and further including an organic functional layer disposed between the emissive layer and the electron transport area, wherein the organic functional layer satisfies the following (i) and (ii) conditions:
(i) the reflective index (nF) of the organic functional layer is the same as or greater than that (nEM) of the emissive layer; and
(ii) the organic function layer has a HOMO energy (EHOMO) of 5.5 eV or greater.

In an embodiment of the present invention, the organic functional layer is in direct contact with the emissive layer, with a reflective index difference between the organic functional layer and the emissive layer (ΔnF - nEM) ranging from 0 to 1.0.

In an embodiment of the present invention, the organic functional layer may have a reflective index of 1.5 to 2.5.

In an embodiment of the present invention, the organic functional layer may have a reflective index of 1.8 or greater for the emissive layer which is a blue emissive layer containing a fluorescent blue light-emitting material.

In an embodiment of the present invention, the organic functional layer may have a HOMO energy of 5.5 to 6.5 eV.

In an embodiment of the present invention, the electron transport area may include an auxiliary electron transport layer, an electron transport layer, and an electron injection layer and the organic functional layer may be an auxiliary electron transport layer.

### Advantageous Effects of Invention

Provided according to the present invention is an organic EL device in which an organic functional layer is disposed in direct contact with an emissive layer, with an identical or greater reflective index given to the organic functional layer compared to the emissive layer, whereby the organic EL device can exhibit a low driving voltage and a high emission efficiency. In addition, the application of the organic EL device of the present invention can provide a display panel with improved performance and lifespan.

The advantages according to the present invention are not limited to the contents illustrated above, and more various advantages are included in the specification.

### Brief Description of Drawings

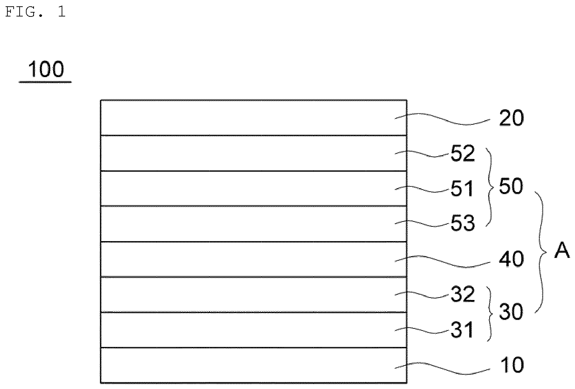

FIG. 1 is a cross-sectional view illustrating a structure of an organic EL device according to an embodiment of the present invention.

### DESCRIPTION OF MAIN REFERENCE NUMERALS OF DRAWINGS

100: organic electroluminescence device
A: organic material layer
10: anode
20: cathode
30: hole transport area
31: hole injection layer
32: hole transport layer
40: emissive layer
50: electron transport area
51: electron transport layer
52: electron injection layer
53: organic functional layer (auxiliary electron transport layer)

Mode for Carrying out the Invention

Hereinafter, embodiments of the disclosure will be described in detail with reference to the accompanying drawings. In the following description of the disclosure, a detailed description of known functions or ~ Advantages and features of the present invention and methods for achieving them will become apparent with reference to the embodiments described below in detail in conjunction with the accompanying drawings. However, the present invention is not limited to the embodiments disclosed below but may be implemented in various different forms, the present embodiments are merely provided to make the disclosure of the present invention complete and to fully convey the scope of the present invention to those of ordinary skill in the art, and the present invention is defined only by the scope of the claims. Thus, in some embodiments, well-known process steps, well-known device structures and well-known techniques are not described in detail in order to avoid obscuring the present invention. Like reference numerals refer to like elements throughout the specification.

Unless otherwise defined, all terms used in the present specification (including technical and scientific terms) may be used with meanings that can be commonly understood by those skilled in the art. In addition, the terms defined in the commonly used dictionaries are not ideally or excessively interpreted, unless they are specifically defined clearly.

### <Organic Electroluminescent Device>

An organic EL device according to an embodiment of the present invention includes an anode, a cathode disposed facing the anode, and at least one organic layer interposed between the anode and the cathode, wherein the at least one organic layer includes a hole transport area, an emissive layer, and an electron transport area, and an organic functional layer having specific properties, for example, a reflective index and a HOMO energy, adjusted into predetermined ranges is interposed between the emissive layer and the electron transport area.

Hereinafter, preferred embodiments of the organic EL device according to the present invention will be described with reference to the accompanying drawings. However, embodiments of the present invention may be modified in various other forms, and the scope of the present invention is not limited to the embodiments described below.

FIG. 1 is a cross-sectional view illustrating a structure of an organic EL device according to an embodiment of the present invention.

Referring to FIG. 1, an organic EL device (100) includes a structure including: an anode (10); a cathode (20); an emissive layer (40) disposed between the anode (10) and the cathode (20); a hole transport area (30) disposed between the anode (10) and the emissive layer (40); and an electron transporting area (50) disposed between the emissive layer (40) and the cathode (20), and an organic functional layer interposed between the emissive layer (40) and the electron transport area (50) and having properties such as reflective index and HOMO energy, adjusted within predetermined ranges.

In the organic EL device, the electron transport area (50) includes an auxiliary electron transport layer (53), an electron transport layer (51), and an electron injection layer (52), and the organic functional layer may be an auxiliary electron transport layer (53) disposed between the emissive layer (40) and the electron transport layer.

### Anode

In the organic EL device (100) according to the present invention, the anode (10) serves to inject holes into an organic layer (A).

No particular limitations are imparted to the constituent of the anode (10) is not particularly limited, and conventional materials known in the art may be used. Non-limiting examples thereof include: metals such as vanadium, chromium, copper, zinc and gold; alloys thereof; metal oxides such as zinc oxide, indium oxide, indium tin oxide (ITO) and indium zinc oxide (IZO); combinations of metals and oxides such as ZnO:Al and SnO₂:Sb, conductive polymers such as polythiophene, poly(3-methylthiophene), poly[3,4-(ethylene-1,2-dioxy)thiophene] (PEDT), polypyrrole and polyaniline; and carbon black.

A method of manufacturing the anode (10) is not particularly limited, either, and any conventional methods known in the art may be employed for manufacturing the anode. For example, a method of coating an anode material on a substrate formed of a silicon wafer, quartz, a glass plate, a metal plate or a plastic film may be used.

### Cathode

In the organic EL device (100) according to the present invention, the cathode (20) functions to inject electrons into the organic layer (A).

No particular limitations are imparted to the constituent of the cathode 20. So long as it is known in the art, any conventional material may be used as a constituent for the cathode. Non-limiting examples thereof include metals such as magnesium, calcium, sodium, potassium, titanium, indium, yttrium, lithium, gadolinium, aluminum, silver, tin, and lead; alloys thereof; and multilayer-structured materials such as LiF/Al and LiO₂/Al.

In addition, a method of manufacturing the cathode 20 is not particularly limited, and any conventional method known in the art may be employed.

### Organic layer

The organic layer (A) included in the organic EL device according to the present invention may use, without limitation, any conventional configuration used in an organic material layer of conventional organic EL devices, and may include, for example, one or more selected from the hole transporting area (30), the emissive layer (40), and the electron transport area (50). In consideration of the characteristics of the organic EL device, it is preferable to include all the above-mentioned organic layers.

### Hole Transport Area

The hole transport area (30) included in the organic material layer (A) of the present invention serves to move the holes injected from the anode (10) to the emissive layer (40). The hole transport area (30) may include at least one selected from the group consisting of a hole injection layer (31) and a hole transport layer (32). In this regard, it is preferable to include both the hole injection layer 31 and the hole transport layer 32 described above in light of the characteristics of the organic EL device.

So long as it has a low hole injection barrier and a high hole mobility, any materials known in the art can be used as constituents for the hole injection layer (31) and the hole transport layer (32), without particular limitations. In this regard, the constituents for the hole injection layer (31) and the hole transport layer (32) may be identical to or different from each other.

Any hole injection material known in the art may be used without limitations. Non-limiting examples of available hole injection materials include phthalocyanine compounds such as copper phthalocyanine; DNTPD (N,N'-diphenyl-N,N'-bis-[4-(phenyl-m-tolyl-amino)-phenyl]-biphenyl-4,4'-diamine), m-MTDATA (4,4',4"-tris(3-methylphenylphenylamino)triphenylamine), TDATA (4,4'4"-Tris(N,N-diphenylamino)triphenylamine), 2TNATA (4,4',4"-tris{N-(2-naphthyl)-N-phenylamino}-triphenylamine), PEDOT/PSS (poly(3,4-ethylenedioxythiophene)/poly(4-styrenesulfonate)), PANI/DBSA (polyaniline/dodecylbenzenesulfonic acid), PANI/CSA (polyaniline/camphor sulfonic acid), PANI/PSS (polyaniline)/poly(4-styrenesulfonate)), and the like, which may be used solely or in combination.

In addition, any hole transport material known in the art may be used without limitations. Non-limiting examples of available hole transport materials may include carbazole-based derivatives such as phenylcarbazole, polyvinylcarbazole or the like; fluorine-based derivatives; triphenylamine-based derivatives such as TPD (N,N'-bis(3-methylphenyl)-N,N'-diphenyl-[1,1-biphenyl]-4,4'-diamine), TCTA (4,4',4"-tris(N-carbazolyl)triphenylamine) or the like; NPB (N,N'-di(1-naphthyl)-N,N'-diphenylbenzidine), TAPC (4,4'-cyclohexylidene bis[N,N-bis(4-methylphenyl)benzenamine]), and the like. They may be used solely or in combination thereof.

The hole transport area (30) may be formed through any conventional method known in the art. Examples of the method may include, but are not limited to, a vacuum deposition method, a spin coating method, a cast method, a Langmuir-Blodgett (LB) method, an inkjet printing method, a laser printing method, a laser-induced thermal imaging (LITI) method, and the like.

### Emissive layer

The emissive layer (40) included in the organic layer (A) of the present invention is a layer in which holes and electrons recombine to produce excitons, and the color of light emitted by the organic EL device may vary depending on the constituents of the emissive layer (40).

The emissive layer (40) may include a host and a dopant, and a mixing rate thereof may be appropriately adjusted within a range known in the art. For example, the emissive layer may include the host in an amount of 70 to 99.9 % by weight and the dopant in an amount of 0.1 to 30 % by weight. More specifically, when the emissive layer (40) is of blue fluorescence, green fluorescence, or red fluorescence, the host may be included in an amount of 80 to 99.9 % by weight, and the dopant may be included in an amount of 0.1 to 20 % by weight. In addition, for the emissive layer (40) which is of blue fluorescence, green fluorescence, or red phosphorescence, the host may be included in an amount of 70 to 99 % by weight and the dopant may be included in an amount of 1 to 30 % by weight.

So long as it is known in the art, any host may be included in the emissive layer (40) of the present invention, without limitations, and non-limiting examples thereof include alkali metal complex compounds, alkaline earth metal complex compounds, and condensed aromatic cyclic derivatives.

More specifically, the host material is preferably aluminum complex compounds, beryllium complex compounds, anthracene derivatives, pyrene derivatives, triphenylene derivatives, carbazole derivatives, dibenzofuran derivatives, dibenzothiophene derivatives, or a combination of one or more kinds thereof that may enhance luminous efficiency and lifespan.

In addition, the dopant included in the emissive layer (40) of the present invention is not particularly limited as long as it is known in the art, and non-limiting examples thereof may include anthracene derivatives, pyrene derivatives, arylamine derivatives, and metal complex compounds including iridium (Ir) or platinum (Pt).

Such dopants may be classified into red dopants, green dopants, and blue dopants. Any conventional red, green, and blue dopants known in the art may be used without particular limitation.

More specifically, non-limiting examples of the red dopant include PtOEP (Pt(II) octaethylporphyrin), Ir(piq)₃ (tris(2-phenylisoquinoline)iridium), Btp₂Ir(acac) (bis(2-(2'-benzothienyl)-pyridinato-N,C3')iridium(acetylacetonate)), or a mixture of two or more thereof.

Furthermore, non-limiting examples of the green dopant include Ir(ppy)₃ (tris(2-phenylpyridine)iridium), Ir(ppy)₂(acac) (bis(2-phenylpyridine)(acetylacetonato)iridium(III)), Ir(mppy)₃ (tris(2-(4-tolyl)phenylpiridine)iridium), C545T (10-(2-benzothiazolyl)-1,1,7,7-tetramethyl-2,3,6,7-tetrahydro-1H,5H,11H-[1]benzopyrano[6,7,8-ij]-quinolizin-11-one), or a mixture of two or more thereof.

Furthermore, non-limiting examples of the blue dopant include F₂Irpic (bis[3,5-difluoro-2-(2-pyridyl)phenyl](picolinato)iridium(III)), (F₂ppy)₂Ir(tmd), Ir(dfppz)₃, DPVBi (4,4'-bis(2,2'-diphenylethen-1-yl)biphenyl), DPAVBi (4,4'-bis[4-(diphenylamino)styryl]biphenyl), TBPe (2,5,8,11-tetratert-butylperylene), or a mixture of two or more thereof.

The emissive layer (40) according to the present invention may be a red emissive layer including a red phosphorescent material, a green emissive layer including a green phosphorescent material; or a blue emissive layer including a blue phosphorescent material or a blue fluorescent material, with preference for an emissive layer including a blue fluorescent material.

The emissive layer (40) may be a single layer or a multi-layer of at least two layers. When the emissive layer (40) is a plurality of layers, the organic EL device may emit light having various colors. Specifically, the present invention may provide an organic EL device that can present mixed colors when a plurality of emissive layers composed of different kinds of materials are arranged in series therein. In addition, when a plurality of emissive layers is included, the driving voltage of the device may increase while the current value in the organic EL device become constant, and thus the organic EL device may have luminous efficiency that is improved by the emissive layers employed.

### Electron Transport Area

In the organic EL device (100) according to the present invention, the electron transport area (50) included in the organic material layer (A) functions to move electrons injected from the cathode (20) to the emissive layer (40).

The electron transport area (50) may include at least one layer selected from the group consisting of an electron transport layer (51), an electron injection layer (52), and an auxiliary electron transport layer (53). In light of the characteristics of an organic EL device, it is preferable to include all of the electron transport layer (51), the electron injection layer (52), and the auxiliary electron transport layer (53).

In the electron transport area (50) according to the present invention, the electron injection layer (52) may employ, without limitation, an electron injection material that easily injects electrons and has high electron mobility. Non-limiting examples of available electron injecting materials include bipolar compounds, anthracene derivatives, heteroaromatic compounds, alkali metal complex compounds and the like. Specifically, examples thereof include lanthanum group metals such as LiF, Li₂O, BaO, NaCl, CsF, Yb and the like; or a metal halide such as RbCl, RbI, or the like, which may be used solely or in combination of two or more thereof.

The electron transport area (50) according to the present invention, specifically, the electron transport layer (51) and/or the electron injection layer (52) may be co-deposited with an n-type dopant to facilitate the injection of electrons from the cathode. In this regard, the n-type dopant, may use an alkali metal complex compound known in the art, without limitation, as exemplified by alkali metals, alkaline earth metals, or rare earth metals.

The electron transport area (50) may be manufactured through conventional methods known in the art. Examples thereof include a vacuum deposition method, a spin coating method, a cast method, LB (Langmuir-Blodgett), an inkjet printing method, a laser printing method, Laser Induced Thermal Imaging (LITI) and the like, but are not limited thereto.

The present invention is characterized by further including an organic functional layer (53) disposed between the emissive layer (40) and the electron transport area (50), specifically between the emissive layer (4) and the electron transport layer (51) and having properties, such as reflective index and HOMO energy, adjusted within a predetermined range.

The organic functional layer (53) may have a monolayer structure or a multilayer structure of two or more layers. When the organic functional layer (53) has a multilayer structure of two or more layers, one layer provided with adjusted reflective index and HOMO energy among the multilayer structure of the organic functional layer (53) is preferably disposed in direct contact with the emissive layer (40).

Being interposed between the emissive layer (40) and the electron transport layer (51), the organic functional layer (53) serves as an auxiliary electron transport layer (53) to prevent the diffusion or migration of holes toward the electron transport layer (51). Particularly, when an organic functional layer (53) having properties, such as reflective index, HOMO energy, so on, adjusted within specific ranges is recruited as an auxiliary electron transport layer, holes are blocked by the high energy barrier of the organic functional layer (53) and cannot diffuse or move toward the electron transport layer (51), but remains in the emissive layer (40). Accordingly, the holes and electrons are more likely to recombine in the emissive layer (40) to produce excitons, thereby significantly improving luminous efficiency and lifespan characteristics of the organic EL device.

In addition, when light passes from a material having a small refractive index to a material having a large reflective index, the refractive angle of light becomes smaller than the incident angle, thereby increasing the straightness of light. As stated, when the straightness of light increases, more light may be emitted from the surface of the device, and thus a remarkable synergy effect may be exhibited in terms of luminous efficiency of the device.

In an embodiment of the present invention, the reflective index of the organic functional layer (53) may be identical to or greater than that of the emissive layer (40) .

Specifically, the organic functional layer (53) is disposed in direct contact with the emissive layer (40), with a difference in reflective index between the organic functional layer (53) and the emissive layer (40) (Δn_{F}-n_{EM}) ranging from 0 to 1.0. For instance, the organic functional layer (53) may have a reflective index of 1.5 to 2.5 while the reflective index of the emissive layer (40) may be 1.5 to 1.9. In this regard, the reflective index is based on that measured at a wavelength of 460 nm.

In a particular embodiment according to the present invention, when the emissive layer (40) is a blue emissive layer containing a fluorescent blue emissive material, the organic functional layer (53) may have a reflective index of 1.8 or greater and specifically 1.8 to 2.5.

In another embodiment of the present invention, the organic functional layer (53) may have a HOMO energy of 5.5 to 6.5 eV, specifically 5.5 to 6.2 eV. a HOMO energy of 5.5 eV or more given to the organic functional layer (53) is higher than that given to the emissive layer (40), thus preventing the phenomenon that holes transferred to the emissive layer (40) diffuses or moves toward the electron transport layer (51). Accordingly, the probability that holes and electrons recombine within the emissive layer (40) increases, which may lead to an increase in the luminous efficiency of the organic EL device. In addition, the irreversible decomposition reaction by the oxidation caused by the diffusion or migration of holes over the electron transport layer (51) toward the emissive layer (40) and the resulting decrease in the lifespan of the organic EL device can be solved, thereby improving the lifespan characteristics of the device.

In another embodiment of the present invention, the organic functional layer (53) may be greater or smaller in triplet energy (T1) than the emissive layer (40). For instance, when the triplet energy of the organic functional layer (53) is greater than that of the emissive layer (40), the TTA effect, together with the above-described reflective index effect, can lead to a significant increase in the efficiency of the organic EL device. In contrast, when the organic functional layer (53) is smaller in smaller triplet energy than the emissive layer (40), the reflective index effect can compensate for the decrease in the luminous efficiency of the device. In an embodiment, the organic functional layer (53) has a triplet energy (T1) of 1.5 to 3.0 eV.

In order to function as an auxiliary electron transport layer, the organic functional layer (53) according to the present invention may meet at least one of the properties described below.

Specifically, the constituent compound of the organic functional layer (53) may exhibit a difference between HOMO and LUMO values (E_{HOMO}-E_{LUMO}) of 3.0 eV or greater and specifically 3.0 eV to 3.5 eV. In addition, the compound may have a difference between singlet energy (S₁) and triplet energy (T₁) (ΔEst) of less than 0.5 eV and specifically 0.01 eV (inclusive) to 0.5 eV (exclusive). The employment of the compound having the above-stated properties in the auxiliary transport layer (53) can prevent the diffusion of the excitons produced in the emissive layer (40) into the electron transport layer (51) and the occurrence of the phenomenon of light emission at an interface between the emissive layer (40) and the electron transport layer (51), bringing about preventing spectral mixing of the organic EL device and improving stability, with the consequent prolong lifespan of the organic EL device.

The compound included as a material for the organic functional layer (53) according to the present invention may be a bipolar compound containing both an electron withdrawing group (EWG) moiety with large electron absorptivity and an electron donor group (EDG) moiety with high electron donating properties.

Bearing both the EDG group and the EWG group, the bipolar compound exhibits the characteristic of separating electron clouds of HOMO and LUMO. Due to this molecular orbit trait, the difference between triplet and singlet energies (ΔEst) in the compound itself is small, satisfying the relationship of ΔEst < 0.5 eV. Thus, a high triplet energy (T1) may be achieved even when the difference (E_{HOMO}-E_{LUMO}) between HOMO and LUMO values is 3.0 eV or more.

If a numerical unbalance occurs due to a difference in number between holes injected from the anode (10) and electrons injected from the cathode (20), the electrons or holes that do not produce excitons through recombination are accumulated in the emissive layer (40). The electrons or holes accumulated in the emissive layer (40) may hinder smooth oxidation and reduction in the emissive layer (40) or may affect adjacent layers to reduce the lifespan of the organic EL device.

In contrast, as the bipolar compound has a hole electron mobility and/or electron mobility of 1×10⁻⁶ cm²/V·s or more at room temperature, the application of the bipolar compound to the organic functional layer (53) prevents the delay of injection of electrons relative to the number of holes injected from the anode (10), whereby the lifespan of the organic EL device can be improved. Indeed, the bipolar compound included in the organic functional layer (53) of the present invention exhibits a hole mobility of 1×10⁻⁶ cm²/V·s or higher at room temperature due to the EDG and an electron mobility of 1×10⁻⁶ cm²/V·s or higher at room temperature due to the EWG. Therefore, the organic functional layer (53) containing the bipolar compound allows electrons to be smoothly injected to the emissive layer (40) to increase the exciton forming efficiency in the emissive layer (40), thereby improving the lifespan of the organic EL device.

In an embodiment, any condensed polycyclic compound known in the art may be used as the EDG moiety of the bipolar compound, without limitation. In a concrete embodiment, the bipolar compound may be a condensed polycyclic aromatic moiety in which at least three moieties or specifically three to six moieties selected from a 6-membered moiety represented by the following Formula 1; and a 5-membered moiety represented by the following Formula 2 are condensed: 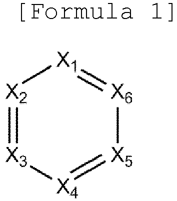 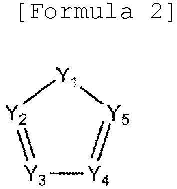 wherein,
X₁ to X₅ and Y₁ to Y₅, which may be same or different, are each independently C(R₁),
wherein when C(R₁) is plural in number, the plurality of R₁ may each be independently selected from the group consisting of: hydrogen, deuterium, a halogen group, a cyano group, a nitro group, an amino group, a C₁-C₄₀ alkyl group, a C₂-C₄₀ alkenyl group, a C₂-C₄₀ alkynyl group, a C₃-C₄₀ cycloalkyl group, a heterocycloalkyl group of 3-40 nuclear atoms, a C₆-C₆₀ aryl group, a heteroaryl group of 5 to 60 nuclear atoms, a C₁-C₄₀ alkyloxy group, a C₆-C₆₀ aryloxy group, a C₁-C₄₀ alkylsilyl group, a C₆-C₆₀ arylsilyl group, a C₁-C₄₀ alkylboron group, a C₆-C₆₀ arylboron group, a C₁-C₄₀ phosphine group, a C₁-C₄₀ phosphine oxide group, and a C₆-C₆₀ arylamine group, or may be bonded with an adjacent group to form a condensed ring,
the alkyl group, the alkenyl group, the alkynyl group, the aryl group, the heteroaryl group, the aryloxy group, the alkyloxy group, the cycloalkyl group, the heterocycloalkyl group, the arylamine group, the alkylsilyl group, the alkylboron group, the arylboron group, the phosphine group, the phosphine oxide group, and the arylamine group of R₁ may each be independently substituted or unsubstituted with one or more kinds of substituents selected from the group consisting of hydrogen, deuterium (D), halogen, a cyano group, a nitro group, a C₁-C₄₀ alkyl group, a C₂-C₄₀ alkenyl group, a C₂-C₄₀ alkynyl group, a C₃-C₄₀ cycloalkyl group, a heterocycloalkyl group having 3 to 40 nuclear atoms, a C₆-C₆₀ aryl group, a heteroaryl group having 5 to 60 nuclear atoms, a C₁-C₄₀ alkyloxy group, a C₆-C₆₀ aryloxy group, a C₁-C₄₀ alkylsilyl group, a C₆-C₆₀ arylsilyl group, a C₁-C₄₀ alkylboron group, a C₆-C₆₀ arylboron group, a C₁-C₄₀ phosphine group, a C₁-C₄₀ phosphine oxide group and a C₆-C₆₀ arylamine group, and when the substituents are plural in number, the substituents may be the same as or different from each other.

Non-limiting examples of the polycyclic aromatic moiety having the EDG characteristic include condensed polycyclic rings such as triphenylene, fluoranthene, fluorene, and so on. In addition to exhibiting the EDG characteristic of high electron donating ability, the condensed polycyclic aromatic moiety has an improved glass transition temperature (Tg) and high thermal stability due to its high molecular weight and thus is superb in thermal stability and chemical resistance, thereby making a great contribution to the durability and long lifespan characteristic of the organic EV device.

An example of the polycyclic aromatic ring moiety of the present invention may be concreted by any one selected from the group of the following structural formulas: 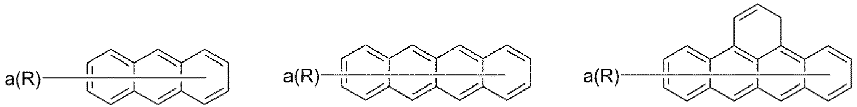 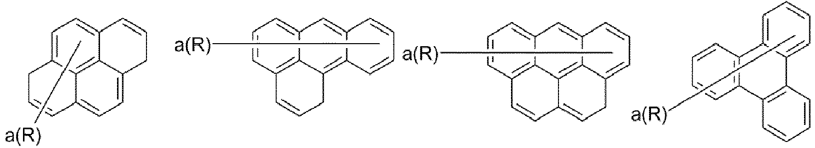 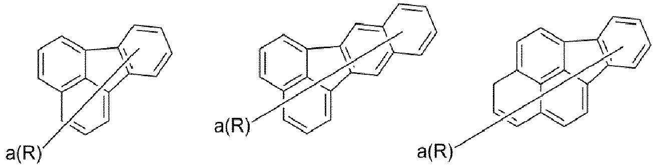 wherein,
when R is plural in number, the plurality of R, which may be same or different, are each independently selected from the group consisting of hydrogen, deuterium, a halogen group, a cyano group, a nitro group, a C₁-C₄₀ alkyl group, a C₂-C₄₀ alkenyl group, a C₂-C₄₀ alkynyl group, a C₃-C₄₀ cycloalkyl group, a heterocycloalkyl group of 3 to 40 nuclear atoms, a C₆-C₆₀ aryl group, a heteroaryl group of 5 to 60 nuclear atoms, a C₁-C₄₀ alkyloxy group, a C₆-C₆₀ aryloxy group, a C₁-C₄₀ alkylsilyl group, a C₆-C₆₀ arylsilyl group, a C₁-C₄₀ alkylboron group, a C₆-C₆₀ arylboron group, a C₁-C₄₀ phosphine group, a C₁-C₄₀ phosphine oxide group, and a C₆-C₆₀ arylamine group, and a is an integer of 0 to 4.

In detail, R may be selected from the group consisting of hydrogen, deuterium, a halogen group, a cyano group, an alkyl group, a C₆-C₆₀ aryl group, and a heteroaryl group of 5 to 60 nuclear atoms, and a may be 0 or 1.

In a particular embodiment of the present invention, the polycyclic aromatic moiety may be any one selected from the group consisting of the following structural formulas:

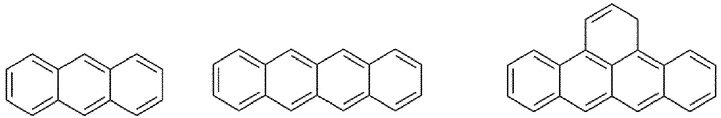

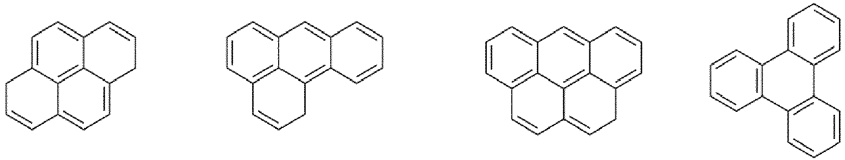

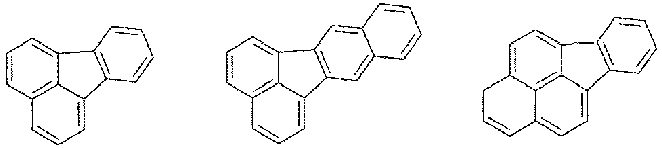

The structural formulas, although not expressed in detail, may have at least one substituent known in the art (e.g., the same as defined for R₁). In addition, although the site (*) at which a bond is made to a compound for the organic functional layer is not marked otherwise in the above structural formulas, the bonding position of the above-mentioned polycyclic aromatic moiety is not particularly limited, and any boning position known in the art may be used. For example, the polycyclic aromatic moiety represented by the above structural formulas may be linked to the compound for the organic functional layer at one or two bonding position.

In addition, the compound used as a material for the organic functional layer (53) includes any known EWG moiety that is greater in electron donating ability than the above-mentioned condensed polycyclic aromatic ring moieties (EDG).

In a particular embodiment, the EWG moiety includes at least one of Formula 3, Formula 4, and a condensed polycyclic moiety in which Formulas 3 and 4 are condensed. 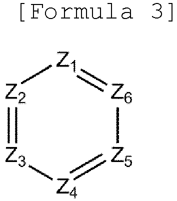 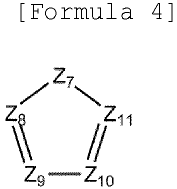 wherein,
Z₁ to Z₁₁, which may be same or different, are each independently N or C(R₂), at least one of Z₁ to Z₁₁ being N. In a particular embodiment, at least one of Z₁ to Z₆ in Formula 3 may be N and at least one of Z₇ to Z₁₁ in Formula 4 may be N.

In this regard, R₂ is plural in number and the plurality of R₂ may be same or different although expressed in a single symbol, and may each form a condensed ring with another R₂. By way of example, a bond may be formed between Z₁-Z₆ which may be C(R₂) in Formula 3, for example, between Z₁ and Z₂, between Z₂ and Z₃, between Z₃ and Z₄, between Z₄ and Z₅, between Z₅ and Z₆, or between Z₆ and Z₁, to generate a condensed ring. Likewise, a bond may be formed between Z₇-Z₁₁ which may be C(R₂) in Formula 4, for example, between Z₇ and Z₈, between Z₈ and Z₉, between Z₉ and Z₁₀, between Z₁₀ and Z₁₁, or between Z₁₁ and Z₇ to generate a condensed ring. Alternatively, R₂ in Formulas 3 and 4 may bond to each other to form a condensed polycyclic heteroaromatic ring.

The plurality of R₂ may be same or different although expressed in a single symbol, and are each independently selected from the group consisting of the group consisting of hydrogen, deuterium, a halogen group, a cyano group, a nitro group, an amino group, a C₁-C₄₀ alkyl group, a C₂-C₄₀ alkenyl group, a C₂-C₄₀ alkynyl group, a C₃-C₄₀ cycloalkyl group, a heterocycloalkyl group of 3 to 40 nuclear atom, a C₆-C₆₀ aryl group, a heteroaryl group of 5 to 60 nuclear atoms, a C₁-C₄₀ alkyloxy group, a C₆-C₆₀ aryloxy group, a C₁-C₄₀ alkylsilyl group, a C₆-C₆₀ arylsilyl group, a C₁-C₄₀ alkylboron group, a C₆-C₆₀ arylboron group, a C₁-C₄₀ phosphine group, a C₁-C₄₀ phosphine oxide group, and a C₆-C₆₀ arylamine group,

the alkyl group, the alkenyl group, the alkynyl group, the cycloalkyl group, the heterocycloalkyl group, the aryl group, the heteroaryl group, the alkyloxy group, the aryloxy group, the alkylsilyl group, the arylsilyl group, the alkylboron group, the arylboron group, the phosphine group, the phosphine oxide group, and the arylamine group of R₂ may each be independently substituted or unsubstituted with one or more kinds of substituents selected from the group consisting of hydrogen, deuterium (D), halogen, a cyano group, a nitro group, an amino group, a C₁-C₄₀ alkyl group, a C₂-C₄₀ alkenyl group, a C₂-C₄₀ alkynyl group, a C₃-C₄₀ cycloalkyl group, a heterocycloalkyl group of 3 to 40 nuclear atoms, a C₆-C₆₀ aryl group, a heteroaryl group of 5 to 40 nuclear atoms, a C₁-C₄₀ alkyloxy group, a C₆-C₆₀ aryloxy group, a C₁-C₄₀ alkylsilyl group, a C₆-C₆₀ arylsilyl group, a C₁-C₄₀ alkylboron group, a C₆-C₆₀ arylboron group, a C₁-C₄₀ phosphine group, a C₁-C₄₀ phosphine oxide group and a C₆-C₆₀ arylamine group, and when the substituents are plural in number, the substituents may be the same as or different from each other.

In detail, the EWG moiety may be a nitrogen-containing mono-/polycyclic heteroaromatic hydrocarbon, such as a 5-membered ring, a 6-membered ring, a heteroaromatic hydrocarbon, or a condensed hydrocarbon thereof, in which one to three carbon members are substituted with nitrogen atoms. Such a nitrogen-containing heteroaromatic ring moiety may in a form where two or more rings are simply pendent to or fused with each other. A form fused with an aryl group may be also included. Non-limiting examples of the nitrogen-containing heteroaromatic hydrocarbon having EWG characteristics include pyridine, pyrimidine, triazine, and pyrazine.

In a particular embodiment of the present invention, the EWG moiety may be concreted by any one selected from the group of the following structural formulas:

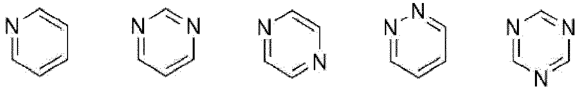

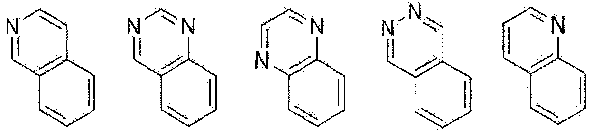

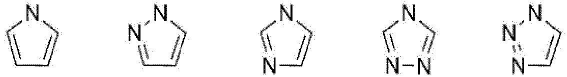

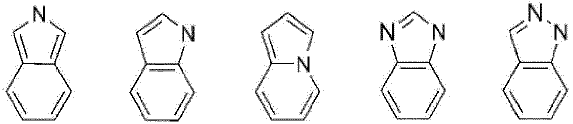

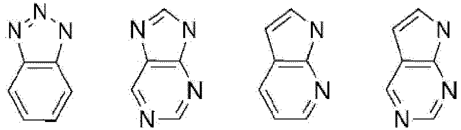

Although not concreted illustrated in the structural formulas, the heteroaromatic rings may have at least one well-known typical substituent, for example, R₂, introduced thereinto. In addition, no particular limitations are imparted to the positions at which a heteroatom is introduced into the structural formulas, and the heteroatom may be introduced at various positions.

In addition, although the site (*) at which a bond is made to a compound for the organic functional layer is not marked otherwise in the above structural formula, the bonding position of the above-mentioned EWG aromatic moiety is not particularly limited, and any boning position known in the art may be used. For example, the EWG moiety represented by the above structural formulas may be linked to the compound for the organic functional layer at one or two bonding position.

The compound for the organic functional layer (53) according to the present invention may have a structure in which the EDG and EWG groups illustrated by the above structural formulas are directly bonded to each other or connected to each other via at least one linker therbetween.

Any divalent linker known in the art may be used without limitations. For instance, the linker may be a single bond or may be selected from a C₆-C₁₈ arylene group and a heteroarylene group of 5 to 18 nuclear atoms. In a concrete embodiment, the linker may be selected from the group consisting of a single bond, phenylene, biphenylene, and triphenylene.

The compounds available as a material for the organic functional layer (53) of the present invention may be more concretely embodied by the compounds to be illustrated below, for example, compounds 1 to 20. However, the compound for the organic functional layer (53) according to the present invention is not limited to those illustrated below. Bonding positions and link introduction positions of the EDG and EWG moieties are not particularly limited as long as they satisfy reflective index and HOMO energy properties. Compounds with various modified chemical structures fall within the scope of the present invention.

The organic functional layer (53) according to the present invention may be formed by a vacuum deposition method, a spin coating method, a cast method, a Langmuir-Blodgett (LB) method, an inkjet printing method, a laser printing method, a laser-induced thermal imaging (LITI) method, and the like, but with no limitations thereto.

### Auxiliary Emissive Layer

Optionally, the organic electroluminescent device (100) according to the present invention may further include an auxiliary emissive layer (not shown) disposed between the hole transport area (30) and the emissive layer (40).

The auxiliary emissive layer serves to transport holes moving from the hole transport area (30) to the emissive layer (40) and to control a thickness of the organic layer (A). The auxiliary emissive layer has a high LUMO value to prevent electrons from moving to the hole transport layer (32) and has a high triplet energy to prevent the excitons of the emissive layer (40) from diffusing into the hole transport layer (32).

The auxiliary emissive layer may include a hole transport material and may be formed of the same material as the hole transport area. In addition, the auxiliary emissive layers of the red, green, and blue organic electroluminescent devices may be formed of the same material.

The material of the auxiliary emissive layer is not particularly limited, and examples thereof may include carbazole derivatives and arylamine derivatives. Non-limiting examples of the auxiliary emissive layers that is applicable may include NPD (N, N-dinaphthyl-N, N'-diphenyl benzidine), TPD (N, N'-bis-(3-methylphenyl)-N, N'-bis(phenyl)- benzidine), s-TAD, and MTDATA (4, 4', 4-tris(N-3-methylphenyl-Nphenyl-amino)- triphenylamine). They may be used solely or in combination of two or more thereof. In addition, the auxiliary emissive layer may include a p-type dopant, in addition to the above materials. As the p-type dopant, a well-known p-type dopant used in the art may be used.

### Capping layer

Optionally, the organic EL device (100) of the present invention may further include a capping layer (not shown) disposed on the cathode (20) described above. The capping layer serves to protect the organic EL device and to help light be efficiently emitted from the organic material layer to the outside.

The capping layer may include at least one selected from the group consisting of tris-8-hydroxyquinoline aluminum (Alq₃), ZnSe, 2,5-bis(6'-(2',2"-bipyridyl))-1,1-dimethyl-3,4-diphenylsilole, 4'-bis [N-(I-napthyl)-N-phenyl-amion] biphenyl (a-NPD), N,N'-diphenyl-N,N'-bis (3-methylphenyl)-1,1'-biphenyl-4,4'-diamine (TPD), and 1,1'-bis(di-4-tolylaminophenyl) cyclohexane (TAPC). A material for such a capping layer is less expensive than materials for other layers of the organic EL device.

The capping layer may be a single layer or may include two or more layers having different refractive indices so that the refractive index gradually changes along the two or more layers.

The capping layer may be manufactured by a conventional method known in the art, and for example, various methods such as vacuum deposition, spin coating, casting, or Langmuir-Blodgett (LB) method may be used.

The organic EL device of the present invention with the above-described configuration may be manufactured according to conventional methods known in the art. For example, the organic EL device may be manufactured by vacuum depositing an anode material on a substrate, followed by vacuum deposition of materials for the hole transporting area, the emissive layer, the electron transporting area, and the cathode on the anode in this order.

The organic EL device (100) according to the present invention has a structure in which the anode (10), the organic layer (A), and the cathode (20) are sequentially stacked and an insulating layer or an adhesive layer may be further included between the anode (10) and the organic layer (A) or between the cathode (20) and the organic layer (A). Such an organic EL device of the present invention may have excellent lifespan characteristics since the lifetime (e.g., half-time) of the initial brightness is increased while maintaining the maximum luminous efficiency when a voltage, a current, or both are applied.

Hereinafter, the present invention will be described in detail with reference to embodiments, but the following embodiments are merely illustrative of the present invention, and the present invention is not limited by the following embodiments.

### [PREPARATION EXAMPLES] Compounds 1 to 20

The compounds of the present invention were prepared as follows. Their reflective indices, HOMO, and triplet energies were measured by methods known in the art and are summarized in Table 1, below. ADN compound was used as a control.
1) The HOMO energy may be an energy level determined from the relative electric potential to a known electric potential of a reference electrode, as measured by CV (cyclic voltammetry) for energy level. By way of example, a material can be measured for HOMO energy level with Ferrocene known for oxidative and reductive electric potentials serving as a reference electrode. In detail, a difference between CV measurements of a material and Ferrocene may be determined as a HOMO energy level for the material.
2) The triplet energy was calculated by the equation B3LYP/6-31G* using the Gaussian program.
3) The reflective index was measured using Ellipsometer (Ellipso Technology) at 25°C under a Tungsten halogen lamp. A measurement was made after the sample was prepared by deposition on a Si wafer in a high-vacuum chamber (10⁻⁷ or less) .

For reference, compounds 1 to 20 used in the Examples of the present invention are as follows:

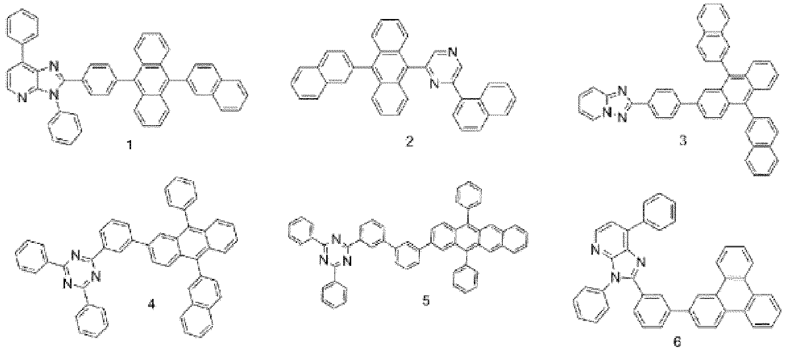

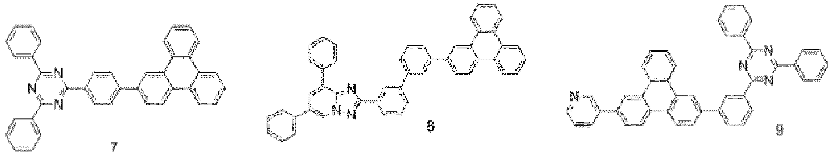

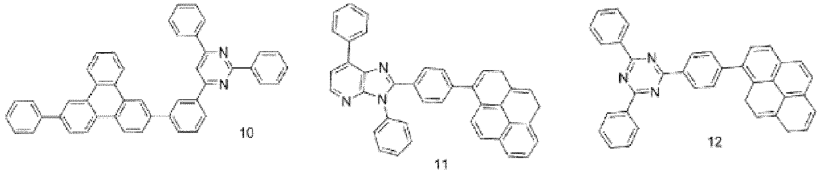

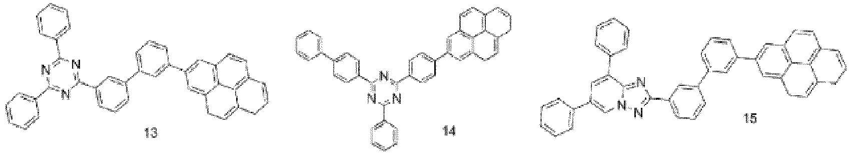

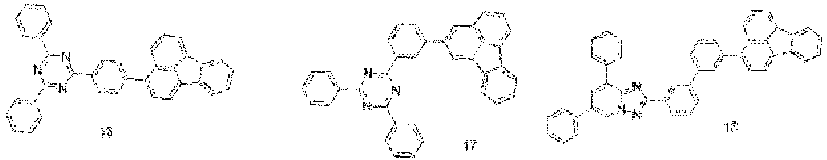

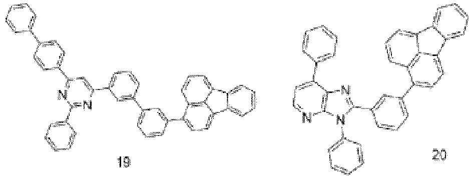

**TABLE 1**

| Compound | Reflective Index | HOMO (eV) |
|---|---|---|
| 1 | 1.91 | 5.76 |
| 2 | 2.04 | 5.63 |
| 3 | 1.97 | 5.74 |
| 4 | 1.87 | 5.82 |
| 5 | 1.94 | 5.73 |
| 6 | 1.86 | 5.92 |
| 7 | 1.85 | 6.07 |
| 8 | 1.92 | 6.08 |
| 9 | 1.89 | 6.12 |
| 10 | 1.90 | 6.10 |
| 11 | 1.84 | 6.05 |
| 12 | 1.92 | 6.07 |
| 13 | 1.86 | 6.11 |
| 14 | 2.01 | 5.89 |
| 15 | 1.98 | 5.76 |
| 16 | 1.89 | 5.87 |
| 17 | 1.92 | 5.94 |
| 18 | 1.90 | 5.76 |
| 19 | 1.87 | 6.13 |
| 20 | 1.88 | 6.08 |
| ADN | 1.82 | 5.12 |
| A | 1.78 | 5.50 |

### [EXAMPLES 1 to 20] Fabrication of Blue Organic Electroluminescent Device

After each compound was subjected to high-purity sublimation purification by a conventionally known method, blue organic EL devices were fabricated as follows.

First, a glass substrate coated with a thin film of indium tin oxide (ITO) at a thickness of 1500 Å was cleansed with distilled water by ultrasonication. After completion of cleansing with distilled water, the glass substrate was ultrasonically cleansed with a solvent, such as isopropyl alcohol, acetone and methanol, dried, transferred to a UV OZONE cleaner (Power sonic 405, Hwasin Tech), cleaned for 5 minutes using UV, and then transferred to a vacuum evaporator.

On the ITO transparent electrode prepared above, DS-205 (Doosan Electronics CO. LTD., 80 nm)/NPB (15 nm)/ADN + 5 % DS-405 (Doosan Electronics CO. LTD., 30 nm)/Compounds of Table 2 (5 nm)/Alq₃ (25nm)/LiF (1 nm)/Al (200 nm) were laminated in the order as listed, thereby fabricating organic EL devices (see Table 2, below).

**TABLE 2**

| | Compound | Thickness (nm) |
|---|---|---|
| Hole injection layer | DS-205 | 80 |
| Hole transport layer | NPB | 15 |
| Emissive layer | ADN + 5% DS-405 | 30 |
| Auxiliary electron transport layer | Compounds 1-20 in Table 2 | 5 |
| Electron transport layer | Alq₃ | 25 |
| Electron injection layer | LiF | 1 |
| Cathode | Al | 200 |

### [COMPARATIVE EXAMPLE 1] Fabrication of Blue Electroluminescent Device

A blue electroluminescent device was fabricated in the same manner as in Example 1, with the exception of not using compound 1 as a material for the auxiliary electron transport layer and depositing Alq₃ as a material for the electron transport layer at a thickness of 30 nm instead 25 nm.

### [COMPARATIVE EXAMPLE 2] Fabrication of Blue Electroluminescent Device

A blue electroluminescent device was fabricated in the same manner as in Example 1, with the exception of material A, instead of compound 1, as a material for the auxiliary electron transport layer.

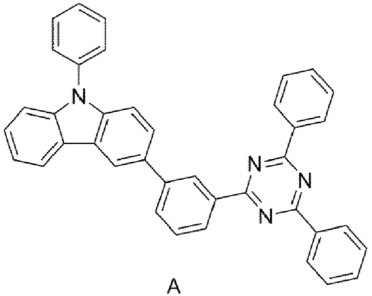

For reference, structures of NPB, ADN, and Alq₃ used in Examples 1 to 20 of the present invention and Comparative Example 1 are as follows:

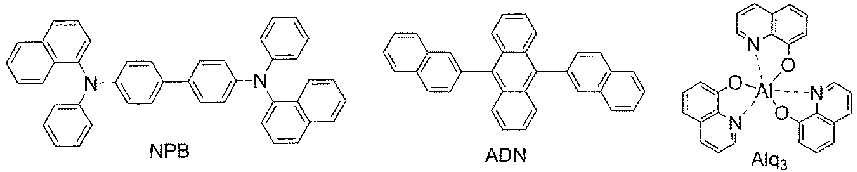

### [EVALUATION EXAMPLE 1]

The organic EV devices fabricated in Examples 1 to 20 and Comparative Example 1 were measured for current density, driving voltage at 10 mA/cm², emission wavelength, and current efficiency, and the results are summarized in Table 3, below.

**TABLE 3**

| Sample | Auxiliary electron transport layer | Reflecti ve index differen ce¹ | Driving Volt. (V) | Emission Peak (nm) | Current Efficiency (cd/A) |
|---|---|---|---|---|---|
| Example 1 | Compound 1 | 0.09 | 4.2 | 456 | 7.8 |
| Example 2 | Compound 2 | 0.22 | 3.9 | 452 | 7.4 |
| Example 3 | Compound 3 | 0.15 | 4.3 | 450 | 8.0 |
| Example 4 | Compound 4 | 0.05 | 4.3 | 452 | 7.9 |
| Example 5 | Compound 5 | 0.12 | 3.8 | 455 | 7.7 |
| Example 6 | Compound 6 | 0.04 | 3.8 | 452 | 7.7 |
| Example 7 | Compound 7 | 0.03 | 4.1 | 455 | 7.8 |
| Example 8 | Compound 8 | 0.1 | 4.1 | 455 | 8.2 |
| Example 9 | Compound 9 | 0.07 | 3.7 | 452 | 8.2 |
| Example 10 | Compound 10 | 0.08 | 4.0 | 455 | 7.4 |
| Example 11 | Compound 11 | 0.02 | 4.0 | 455 | 7.6 |
| Example 12 | Compound 12 | 0.1 | 3.8 | 458 | 7.5 |
| Example 13 | Compound 13 | 0.04 | 4.2 | 455 | 7.9 |
| Example 14 | Compound 14 | 0.19 | 3.9 | 456 | 7.7 |
| Example 15 | Compound 15 | 0.16 | 4.1 | 455 | 8.1 |
| Example 16 | Compound 16 | 0.07 | 4.1 | 458 | 8.2 |
| Example 17 | Compound 17 | 0.1 | 4.2 | 455 | 8.2 |
| Example 18 | Compound 18 | 0.08 | 4.0 | 456 | 7.8 |
| Example 19 | Compound 19 | 0.05 | 4.1 | 455 | 7.8 |
| Example 20 | Compound 20 | 0.06 | 3.9 | 458 | 7.9 |
| C. Example 1 | Alq₃ | - | 4.8 | 458 | 6.2 |
| C. Example 2 | A | -0.04 | 4.5 | 459 | 6.8 |
| Reflective index difference¹ = reflective index of organic functional layer (auxiliary electron transport layer) - reflective index of emissive layer | | | | | |

As shown in Table 3, the blue organic EV devices of Examples 1 to 20 employing the compounds of the present invention as materials for auxiliary electron transport layer were observed to exhibit higher performances in terms of current efficiency, emission peak, and driving voltage, compared to the blue organic EV devices of Comparative Examples 1 and 2, which do not employ the auxiliary electron transport layer and the polycyclic aromatic moiety, respectively.

## Claims

1. An organic electroluminescent device, including a structure in which an anode; a hole transport area; an emissive layer; an electron transport area; and a cathode are sequentially stacked, and
further comprising an organic functional layer disposed between the emissive layer and the electron transport area, wherein the organic functional layer satisfies the following (i) and (ii) conditions:
(i) a reflective index (n_{F}) of the organic functional layer is same as or greater than that (n_{EM}) of the emissive layer; and
(ii) the organic function layer has a HOMO energy (E_{HOMO}) of 5.5 eV or greater.

2. The organic electroluminescent device of claim 1, wherein the organic functional layer is in direct contact with the emissive layer, with a reflective index difference between the organic functional layer and the emissive layer (Δn_{F} - n_{EM}) ranging from 0 to 1.0.

3. The organic electroluminescent device of claim 1, wherein the organic functional layer has a reflective index of 1.5 to 2.5.

4. The organic electroluminescent device of claim 1, wherein when the emissive layer which is a blue emissive layer containing a fluorescent blue light-emitting material, the organic functional layer has a reflective index of 1.8 or greater.

5. The organic electroluminescent device of claim 1, wherein the organic functional layer has a HOMO energy of 5.5 to 6.5 eV.

6. The organic electroluminescent device of claim 1, wherein a compound for the organic functional layer comprises a polycyclic aromatic moiety in which at least three moieties selected from a 6-membered moiety represented by the following Formula 1; and a 5-membered moiety represented by the following Formula 2 are condensed: 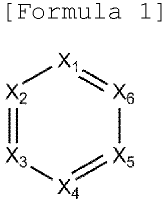 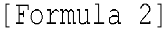 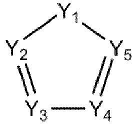 wherein,
X₁ to X₅ and Y₁ to Y₅, which are same or different, are each independently C(R₁), wherein when C(R₁) is plural in number, the plurality of R₁ may each be independently selected from the group consisting of: hydrogen, deuterium, a halogen group, a cyano group, a nitro group, an amino group, a C₁-C₄₀ alkyl group, a C₂-C₄₀ alkenyl group, a C₂-C₄₀ alkynyl group, a C₃-C₄₀ cycloalkyl group, a heterocycloalkyl group of 3-40 nuclear atoms, a C₆-C₆₀ aryl group, a heteroaryl group of 5 to 60 nuclear atoms, a C₁-C₄₀ alkyloxy group, a C₆-C₆₀ aryloxy group, a C₁-C₄₀ alkylsilyl group, a C₆-C₆₀ arylsilyl group, a C₁-C₄₀ alkylboron group, a C₆-C₆₀ arylboron group, a C₁-C₄₀ phosphine group, a C₁-C₄₀ phosphine oxide group, and a C₆-C₆₀ arylamine group, or can be bonded with an adjacent group to form a condensed ring,
the alkyl group, the alkenyl group, the alkynyl group, the aryl group, the heteroaryl group, the aryloxy group, the alkyloxy group, the cycloalkyl group, the heterocycloalkyl group, the arylamine group, the alkylsilyl group, the alkylboron group, the arylboron group, the phosphine group, the phosphine oxide group, and the arylamine group of R₁ may each be independently substituted or unsubstituted with one or more kinds of substituents selected from the group consisting of hydrogen, deuterium (D), halogen, a cyano group, a nitro group, a C₁-C₄₀ alkyl group, a C₂-C₄₀ alkenyl group, a C₂-C₄₀ alkynyl group, a C₃-C₄₀ cycloalkyl group, a heterocycloalkyl group having 3 to 40 nuclear atoms, a C₆-C₆₀ aryl group, a heteroaryl group having 5 to 60 nuclear atoms, a C₁-C₄₀ alkyloxy group, a C₆-C₆₀ aryloxy group, a C₁-C₄₀ alkylsilyl group, a C₆-C₆₀ arylsilyl group, a C₁-C₄₀ alkylboron group, a C₆-C₆₀ arylboron group, a C₁-C₄₀ phosphine group, a C₁-C₄₀ phosphine oxide group and a C₆-C₆₀ arylamine group, and when the substituents are plural in number, the substituents are same as or different from each other.

7. The organic electroluminescent device of claim 6, wherein the polycyclic aromatic ring moiety is selected from the following structural formulas: 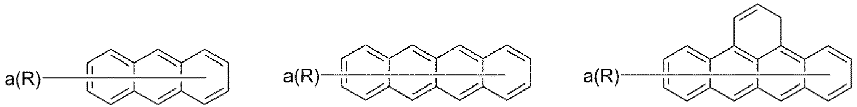 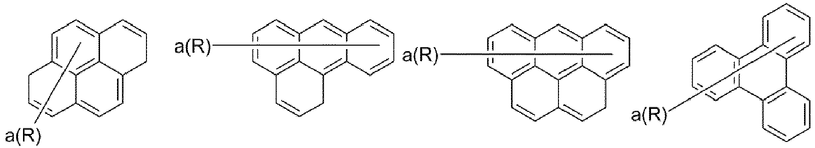 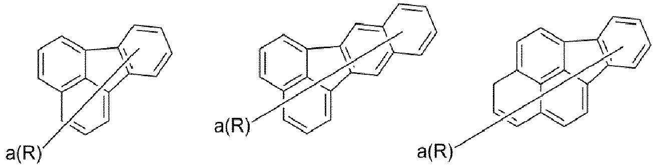 wherein,
when R is plural in number, the plurality of R, which are same or different, are each independently selected from the group consisting of hydrogen, deuterium, a halogen group, a cyano group, a nitro group, a C₁-C₄₀ alkyl group, a C₂-C₄₀ alkenyl group, a C₂-C₄₀ alkynyl group, a C₃-C₄₀ cycloalkyl group, a heterocycloalkyl group of 3 to 40 nuclear atoms, a C₆-C₆₀ aryl group, a heteroaryl group of 5 to 60 nuclear atoms, a C₁-C₄₀ alkyloxy group, a C₆-C₆₀ aryloxy group, a C₁-C₄₀ alkylsilyl group, a C₆-C₆₀ arylsilyl group, a C₁-C₄₀ alkylboron group, a C₆-C₆₀ arylboron group, a C₁-C₄₀ phosphine group, a C₁-C₄₀ phosphine oxide group, and a C₆-C₆₀ arylamine group, and
a is an integer of 0 to 4.

8. The organic electroluminescent device of claim 6, wherein the compound for the organic functional layer further comprises an electron withdrawing group (EWG) moiety larger in electron absorptivity than the polycyclic aromatic ring moiety.

9. The organic electroluminescent device of claim 8, wherein the electron withdrawing group (EWG) moiety is selected from the following structural formulas:

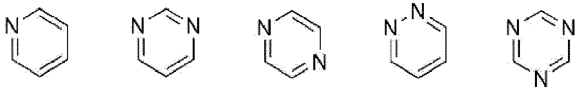

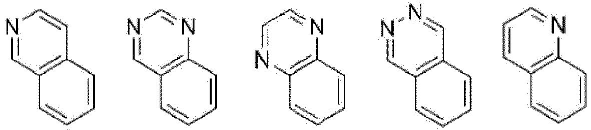

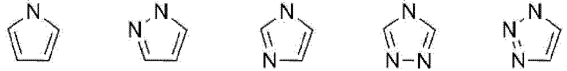

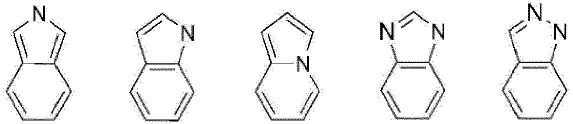

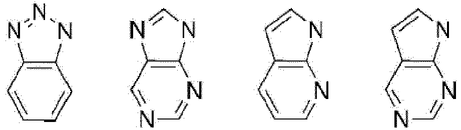

10. The organic electroluminescent device of claim 1, wherein the electron transport area further comprises an auxiliary electron transport layer, an electron transport layer, and an electron injection layer wherein the organic functional layer is the auxiliary electron transport layer.
